(19) Europäisches Patentamt
European Patent Office
Office européen des brevets

(11) **EP 3 220 546 A1**

(12) **EUROPEAN PATENT APPLICATION**

(43) Date of publication:
**20.09.2017 Bulletin 2017/38**

(51) Int Cl.:
*H03K 17/16* (2006.01)    *H03K 17/041* (2006.01)
*H02M 1/08* (2006.01)    *H03F 3/217* (2006.01)
*H03K 17/0412* (2006.01)

(21) Application number: **16161044.9**

(22) Date of filing: **18.03.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicants:
• **Neumüller Elektronik GmbH**
**91085 Weisendorf (DE)**

• **Fischer, Uwe**
**91085 Weisendorf (DE)**

(72) Inventor: **BONDAR, Henri**
**90502 Flic en Flac (MU)**

(74) Representative: **Kruspig, Volkmar**
**Meissner Bolte Patentanwälte**
**Rechtsanwälte Partnerschaft mbB**
**Widenmayerstraße 47**
**80538 München (DE)**

(54) **ELECTRONIC DRIVER CIRCUIT FOR AT LEAST ONE POWER MOSFET AND METHOD OPERATING AT LEAST ONE POWER MOSFET**

(57) The invention relates to an electronic driver circuit (10) for at least one power MOSFET (20) wherein the electronic driver circuit (10) comprises at least one driving signal generator (15) and at least one piezolelectric resonator (25), the output signal of which is applied directly or indirectly to the gate (30) of at least one power MOSFET (20).

Fig. 5a

EP 3 220 546 A1

## Description

The invention relates to an electronic driver circuit for at least one power MOSFET in accordance with claim 1. According to claim 14 the invention also relates to a method of operating at least one power MOSFET with an electronic driver circuit in accordance with the invention.

The present invention relates to the field of electrical power transformation. Primarily concerned here are power converters and highly efficient HF generators based on power MOSFETs.

From the prior art, for the purpose of electrical energy conversion it is known to use a single power MOSFET or a half-bridge or full-bridge arrangement of identical transistors or a push-pull arrangement of complementary transistors. These are normally driven by means of square wave signals, wherein the aspect ratios, the amplitude phase and optionally the dead times depend on the circuit diagram and the transistor properties.

At relatively low switching frequencies the power losses at the output level are the main disadvantages. These problems can be overcome by selecting transistors with a low switch-on resistance $R_{DS(on)}$.

Usually the electronic driver circuit of the MOSFET, regulation and safety devices as well as any possibly present communication devices are grouped together in a specially integrated component.

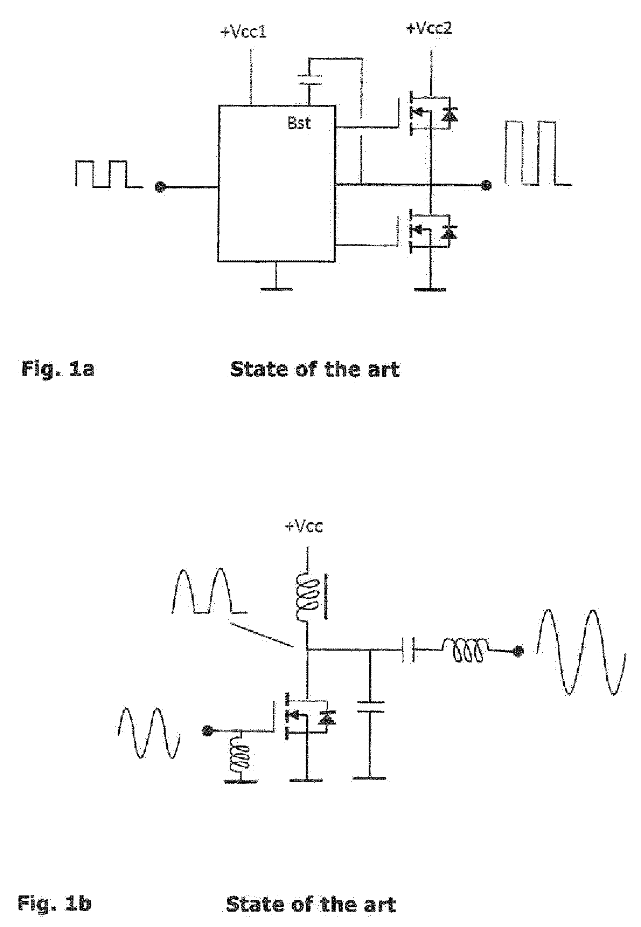

Figure 1a shows a typical low-frequency solution which can be used in the case of frequencies up to around 1 MHz. There is always a desire to increase the operating frequencies of such devices in order increase the power level for a given overall size, or alternatively to reduce the overall size of the device while maintaining the same power level. Power MOSFETs can achieve commutation times in the nanosecond range. However, the conversion losses usually increase very sharply if the frequency is increased to several megahertz.

The commutation losses can largely be reduced through the use of *Zero Current Switching (ZCS)* or *Zero Voltage Switching (ZVS)* conditions.

However, with conventional electronic power circuits it is not possible to operate power MOSFETS at frequencies of above one megahertz. This is due to the relatively high input capacitance of the power MOSFETs. At high frequencies both integrated and discrete solutions result in high input level losses. This applies in particular if the driver signal is a high-frequency square wave signal. In transforming applications the efficiency plays a lesser role. Therefore, for these applications transistors with higher switch-on resistances $R_{DS(on)}$ and lower gate capacities and low threshold voltage values can be used. However, such methods cannot be used for applications at frequencies of over 10 MHz. Above these frequencies both the driving losses and the current superimposition are very high.

Shown in figure 1b is a typical "class E" driver circuit with an RLC oscillation circuit. The gate resonance circuit allows energy stored in the gate to be largely returned in a following change so that the amount of drive power required is reduced. In the presence of resonance the input impedance is therefore much greater.

It is pointed out that although the input and output signals are quasi sinusoidal signals, the transistor operates in switched *mode. Zero Current Switching (ZCS)* can be implemented by careful coordination of the input components.

It is known that electronic driver circuits for power transistors, more particularly for power MOSFETS often exhibit greater currents than the output loops. As a rule, much greater voltages are used in the outlet loops. It is due to this that electronic driver circuits are the main cause of commutation losses and EMI (electromagnetic interference) problems. This problem is, in particular, the result of the higher proportion of harmonics due to the capacitive behaviour of the MOSFET gate.

The current method of reducing driving losses in RF circuits is the use of resonant LC drivers.

The magnitude of the improvement which can be achieved with the aid of a resonant driver circuit for a given transistor depends on its typical quality factor of the gate (Q factor) or on the angle of loss of the gate capacitance: $Q_G = 1/RC_G\omega$. A typical gate resistance lies between 0.1 to 1 Ohm, whereas a typical gate capacitance is between 300 pF to 3000 pF. With a frequency of 10 MHz, the associated Q factor would be in a range of 5 to 500, wherein the Q factor for transistors with lower gate capacitance is higher. Accordingly a resonance driver circuit with a relatively large Q factor leads to a considerable reduction in the drive power.

In existing RF implementations for use in transmissions, at relatively low frequencies in the resonance driver circuits, heavy and cumbersome coils with ferrite cores are used. At frequencies above 1 MHz the use of ferrite cores is no longer possible. As of such frequencies air coils are usually used. Such air coils are generally much larger than ferrite core coils. In order to reduce skin effects, air coils have relatively thick wires and a large quantity of copper material. These air coils are crossed by relatively large currents so that, due to their large dimensions, large magnetic fields are formed even at relatively large distances. Such magnetic fields can only be screened off by other available means in a very complicated and costly manner. Additionally, the air coils must be kept away from conductive materials in order to avoid induced current and consequent damage in a driver circuit. Accordingly, circuits based on coils, more particularly on air coils, cannot be placed in thin metal housings.

In summary it can be stated that even though in some cases they are useful for reducing the drive power, the known RLC resonant drive technologies have very great drawbacks. One of these consists in the fact that the driver circuits have relatively large dimensions, more particularly at frequencies above existing ferrite limits. Additionally on the basis of the known devices a relatively large emission field is produced.

In US 5,264,736 A or US 7,453,292 B2 and US 7,285,876 B1 examples of resonant drives are disclosed which are formed by arrangements of coils and resonant transformers.

On the basis of what has been previously described, the aim of the invention is therefore to provide an electronic driver circuit so that electromagnetic interferences are reduced. In addition, the frequency limits of conventional current transformers are to be increased or heightened. The use of large coils which produce magnetic fields that can only be screened off with difficulty or extremely cost-intensively is to be dispensed with.

The aim is achieved through an electronic driver circuit for at least one power MOSFET comprising at least one driving signal generator and at least one piezoelectric resonator, the output signal of which is applied directly or indirectly to the gate of at least one power MOSFET.

At least one piezoelectric resonator can be connected in parallel or in series with the driving signal generator. In other words, the aim is achieved through combining a piezoelectric resonator or several piezoelectric resonators with suitable electronic circuits.

The use of piezoelectric resonators is based on several general considerations:

Above a critical level, which is dependent on the MOSFET, it is not rational to increase the rate of rise at gate level. At high frequencies the use of a sinusoidal signal instead of a square wave input signal at gate level leads to a negligible increase in switching losses. For intermediate frequencies an optimum rate of rise with a greater gate voltage amplitude is obtained. In turn, the lowest operating frequency is obtained if the required rate of rise of the threshold voltage to the maximum peak-peak value which is permissible for the device is reached. The maximum rate of rise for a perfect sinusoidal wave is indicated by the following formula:

$$\left(\frac{dV}{dt}\right)_{max} = \omega V_{PP}$$

At a later point it will be described how the rate of rise at the threshold level can be further improved without having to exceed the limit of the peak-peak voltage.

The gate of a MOSFET or power MOSFET exhibits a natural capacitive behaviour at a relatively high Q factor (relatively low angle of loss). On the basis of this it is advantageous if a component that acts as inductance is used in order to obtain a resonance associated with the described improvements.

Furthermore, the component should have a relatively large Q factor at a desired frequency.

In accordance with the invention a piezoelectric resonator or a combination of several piezoelectric resonators in conjunction with a suitable circuit is used as the component in order to achieve the desired requirements or results. In connection with the piezoelectric resonator, due to the large number of known materials and frequencies, a variety of configurations is possible in relation to the piezoelectric resonator. In a simplest form of embodiment of the invention standard piezoelectric resonators can be used. These resonators mainly consist of a thin lead-zirconate-titanate (PZT) plate, wherein this plate is arranged between two electrodes. A piezoelectric resonator of this type vibrates in thickness mode, which normally provides the highest electromechanical coupling coefficient. Depending on the frequency, the device size and the manufacturer, the electric Q factors, which are defined as the inverse of the loss angle, are between 10 and 100 at frequencies of 2 - 20 MHz.

In a further form of embodiment of the invention it is possible for a piezoelectric resonator to be designed in order to exhibit suitable resonance frequencies, Q factors and impedance values at the power level.

It is possible for the electrical circuit to be associated with parallel or series resonance systems, more particularly with parallel or series-connected piezoelectric resonators. In both the parallel and also series arrangement of piezoelectric resonators it is possible for the driving signal generator to generate square wave signals or sinusoidal signals. In the case of square wave signals it is preferable to connect the driving signal generator in series to the at least one piezoelectric resonator as the low impedance is only obtained for the fundamental frequency. In this way harmonics are rejected, particularly if the quality factor of the circuit is very high.

Most existing standard piezoelectric resonators exhibit their best performance at capacitive loads that are much smaller than the usual total gate capacitance of known transistors. In a preferred form of embodiment of the invention the electronic driver circuit has an impedance-matching unit. Preferably an impedance-matching unit is connected between at least one piezoelectric resonator and the gate of at least one power MOSFET. In a simple form of embodiment of the invention the impedance-matching unit has several piezoelectric resonators connected in parallel.

Typical piezoelectric resonators can withstand much greater voltages than the gate of conventional transistors. It is possible to design the impedance-matching unit as a capacitive bridge divider. For example, a capacitive bridge divider can be formed by a first capacitor which is connected in series to the gate of the power MOSFET. The impedance-matching unit can comprise at least one first capacitor which is connected in series to the gate of the power MOSFET.

In a further form of embodiment of the invention the impedance-matching unit comprises at least one second capacitor which is connected in parallel to an arrangement formed by the first capacitor and the input capacitance of the power MOSFET. If the bridge device or only the first used capacitor produces too great a voltage at the gate level, the second capacitor can be connected in parallel to the bridge divider in order to generate an expected capacitance for the matching gate voltage.

The impedance-matching unit can also be designated as a capacitive divider. This is used to generate an optimum load capacitance for the piezoelectric resonator and the corresponding voltage at gate level. Optimum load capacitances for piezoelectric resonators are typically 10 pF. If the generated output capacitance is optimal, the piezoelectric voltage in the case of resonance can reach value of more than 100 volts. A capacitive divider is necessary in order to reduce the voltage at gate level. Typically the gate capacitance value is a few 10 pF in connection with trench FET technology or a few 100 pF in the case of older MOSFETs. In most cases the capacitance, resulting from the series arrangement of the first capacitor and the input capacitance of the MOSFET, which produces the corresponding voltage at gate level, is lower than the optimum capacitance of the piezoelectric resonator. In such cases the second capacitor is added in order to produce the correct load capacitance for the at least one piezoelectric resonator.

The number of piezoelectric resonators or the values of the capacitors used in the impedance-matching units can be adjusted so as to obtain the smallest input power or the required operating frequency. In connection with the frequency adjustment there is a certain amount of leeway as the overall Q factor is not generally very high and is also only slightly dependent on the external capacitance associated with the piezoelectric resonator.

In a further form of embodiment of the invention it is possible for the electronic driver circuit to have a resistive voltage divider. As are result of this, through providing a resistive voltage divider or a resistive bridge, it is possible to produce a voltage offset at gate level. This offset is used, for example, to set the highest point of the rate of rise close to the threshold voltage of the transistor so that the largest rate of rise for the output voltage can be achieved. This offset voltage can also be used to set the time between the "On" and "Off" events. This this known as dead time control. Here the "ON" event on the transistor is delayed whereas in series transistors the "OFF" was only turned.

In the electronic driver circuit according to the invention, a resistive voltage divider, for example, is connected between a reference voltage and earth, wherein the intermediate voltage is present at the gate of the at least one power MOSFET, particularly such that a voltage offset is present at the gate.

In a further form of embodiment of the invention, between at least one piezoelectric resonator and the gate of at least one power MOSFET there is at least one clipping unit, wherein the clipping unit comprises at least two diodes, more particularly at least two clipping diodes or at least two varactors. The use of clipping diodes ensures that the gate voltage does not exceed the limits of the MOSFET.

A further possibility of increasing the rate of rise in the region of the threshold values is to bring about a non-linear capacitive behaviour through the use of varactors. In the simplest case the aforementioned clipping diodes can be replaced by varactors. Close to the clipping voltage varactors have a greater capacitance value. This results in a change in the signal form. Close to the clipping voltage the signal form is rounded off so that a signal form is generated which is more like a square wave signal. The difference with regard to the aforementioned clipping method is that a large part of the energy is not lost, but is stored in the non-linear capacitance process. This stored energy is released as soon as the voltage is no longer close to the clipping voltage.

Near the forward voltage the diodes or varactors preferably have a high capacitance value.

In the case of sinus wave signals, greater rates of increase can only be achieved by increasing the signal amplitude. In such cases the peak voltage can result in breakage of the gate oxide layer in the transistor. Accordingly the peak voltages have to be clipped in a certain way. Said diodes or varactors have the greatest transition capacitance shortly before conductance and thus shortly before the clipping. The described closeness of the forward voltage, when the diodes or varactors have a high capacitance value, is present, for example, when the voltage of the diode deviates from the forward voltage by around 1 volt.

Shortly before the clipping voltage, and thus the dissipation, is reached, a large part of the vibration energy is stored a reversible manner in the diode capacitance. This vibration energy is therefore not lost. At the same time an almost square wave signal is produced, even if the clipping voltage has not been fully reached. In other words, a sharp increase in capacitance close to the peak voltages leads to voltage restrictions but without losses occurring.

It is possible to provide the described varactors or capacitance diodes before the impedance-matching unit. As the voltage values and capacitance values of a varactor diode are both generally relatively high and low, it may be advisable to arrange the capacitance diodes/varactors before the impedance-matching unit. The diodes connected in series with regard to each other can on the one hand be connected between two voltage references, in particular the earth or the source of the power MOSFET, and on the other hand to the gate of the power MOSFET.

Preferably the diodes are arranged in such a way that the voltage applied at the gate of the power MOSFET can assume a value between the two voltage references and value of the voltage references can only be exceeded up to the value of the voltage references of the diodes.

In a further form of embodiment of the invention it is possible that a capacitor which on the one hand is connected to earth or the source of the power MOSFET and on the other hand to an anode of the diodes, is provided in the electronic driver circuit.

In this form of embodiment, in the case of continuous regulation, the voltage at the capacitor is the peak-peak voltage of the input square wave signal. In this way the diodes can remain blocked, but come relatively close to conduction if the input voltage reaches a values that is near the peak voltages (Vpp for the upper diode and 0 volts for the lower diode). This implementation always allows the greatest capacitance for the diodes, without, however making conduction possible. In one form of embodiment it is possible for a resistor or a Zener diode to be connected in parallel with the capacitor. In this way it is possible to suppress temporary overvoltages. The capacitor can also be discharged in the event of an accidental input overvoltage. The capacitance of a capacitor, which on the one hand is connected to earth or the source of the power MOSFET and on the other hand with the anode of the diodes, is preferably greater than the capacitance of the diodes.

It is pointed out that all the previously mentioned methods and units which can be included in the electronic driver circuit, can be combined with each other in any desired manner. This relates, for example, to impedance matching, frequency tuning, the offset, the clipping method as well as the conversion of the signal form.

In a further form of embodiment of the invention it is possible for a first electronic driver circuit according to the invention to be combined with at least one further electronic driver circuit according to the invention.

It is possible for two power MOSFETs to be arranged in a half-bridge driver circuit and/or four power MOSFETs to be arranged in in a full-bridge driver circuit.

A further aspect of the invention relates to a method of operating at least one power MOSFET with an electronic driver circuit in accordance with the invention. In accordance with the invention the output signal of the at least one piezoelectric resonator which exhibits the resonance frequency of the piezoelectric resonator is forwarded as the input signal to the gate of the at least one power MOSFET.

The output signal can also be modified by impedance matching and/or frequency tuning and/or a clipping method and/or through offsetting, wherein the modified output signal is forwarded as the input signal to the gate of the at least one power MOSFET.

The electronic driver circuit according to the invention and/or the method according to the invention of operating at least one power MOSFET can be used, for example, in connection with a single power MOSFET. For this a low current input is required, wherein the frequency of the signal produced by the driving signal generator is above the hitherto known range of integrated drivers. For example, conventional CMOS logic or TTL logic can be used to forward the input square wave signal to the piezoelectric resonator.

In other words, the electronic driver circuit can include a CMOS logic module and/or a TTL logic module. An advantage of the present invention can be seen in the fact that the input circuit does not act on magnetic fields of coils arranged in the vicinity. In comparison with classic resonant drivers, no strict separation between the input circuit and the output circuit is therefore necessary. The electronic driver circuit according to the invention can therefore be designed to be more compact and with a lighter weight. The electronic driver circuit according to the invention can be incorporated into a single housing. Preferably the electronic driver circuit is extremely thin and flexible. In one form of embodiment of the invention two complementary power MOSFETs can be arranged and/or operated in the form of a classic push-pull system.

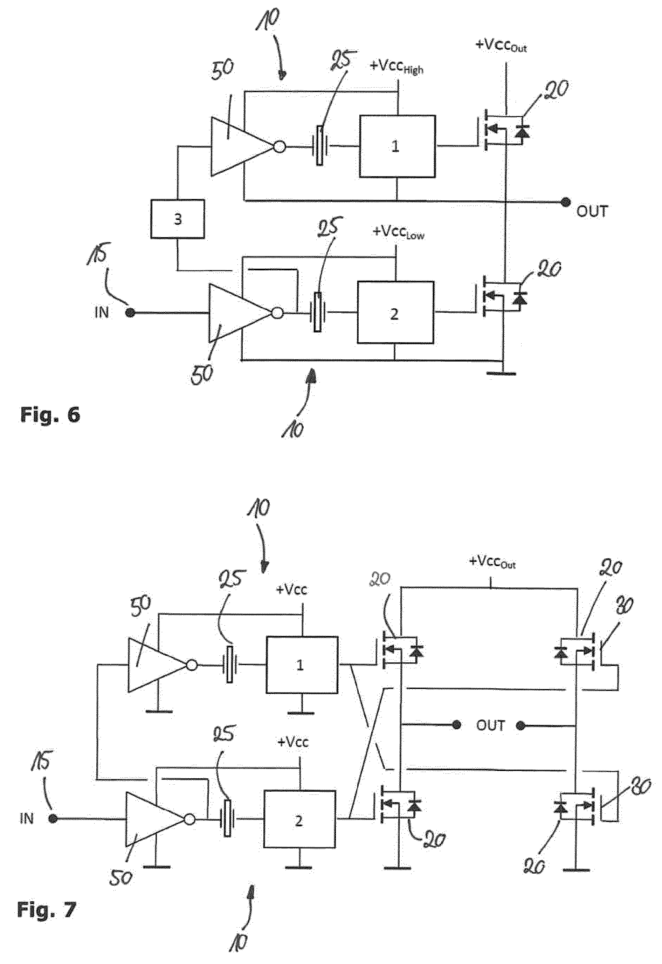

As has already been mentioned, two power MOSFETs can be arranged in a half-bridge driver circuit and/or four power MOSFETs in a full-bridge driver circuit. In an embodiment of this type the upper side (see fig. 6 with regard to this) can be driven by a level shifter method and through a bootstrap method. It should be pointed out that such a resonance method is suitable for a circuit which is being operated in a permanently oscillating system (fully resonant converter).

At high frequencies switching transistor losses can only be reduced if *Zero Current Switching (ZCS)* or *Zero Voltage Switching (ZVS)* conditions are achieved. These conditions require the use of a resonant load circuit. Pulse width modulation (PWM) methods are not suitable for such circuits as they do not satisfy ZCS conditions for all aspect ratios.

The simplest possibility of controlling the output voltage is to set the output driver voltage.

The operating frequency in connection with the electronic driver circuit is very high. Constant regulation is therefore carried out within a relatively short time. Typically the regulation time is a few microseconds. This makes regulation methods possible that are based, for example, on burst duration modulation. Such methods are also known as burst mode regulation. As the piezoelectric resonators can be designed to be very thin and compact, they can be integrated into a circuit as well as into a housing with all the required discrete elements. The electronic driver circuit can, together with the MOSFETs, be integrated into a single standard SOP housing.

The invention will be described below by way of examples of embodiment as well as with the aid of the figures.

Here:

Fig. 2a and 2b    show a basic electronic driver circuit with a piezoelectric resonator connected in parallel or in series;

Fig. 3a and 3b    show various forms of embodiment in terms of possible impedance-matching units;

Fig. 4a    shows the additional provision of an ohmic voltage divider;

Fig. 4b and 4c    show the provision of clipping units;

Fig. 5a - 5c     show forms of embodiment in terms of the combination of several matching units;

Fig. 6     shows a half-bridge circuit; and

Fig. 7     shows a full-bridge circuit.

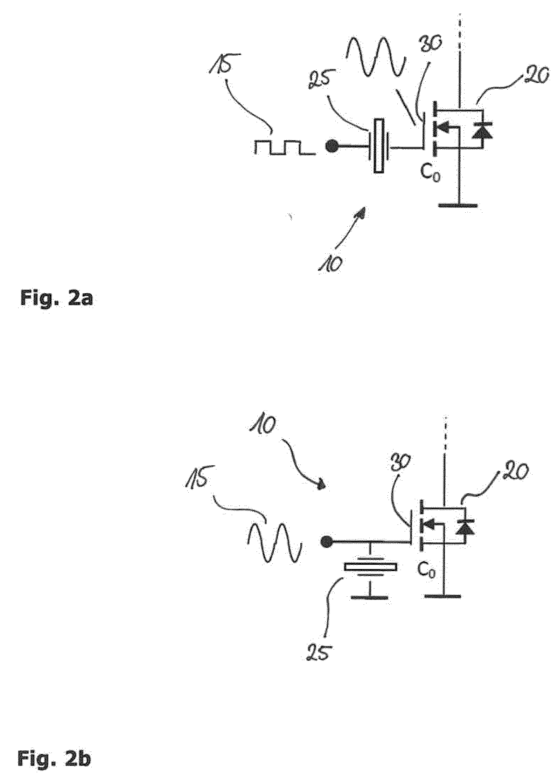

In fig. 2a an electronic driver circuit 10 for at least one power MOSFET is disclosed. With this a series resonance implementation is disclosed. According to fig. 2a a driving signal generator 15 produces a square wave signal. The illustrated piezoelectric resonator 25 is connected in series with the driving signal generator 15. In the form of embodiment shown in fig. 2a the impedance is low when the resonance frequency is present, whereas the impedance is very high at other frequencies. In addition to the shown generation of a square wave signal by the driving signal generator 15, this also allows the use of a sinus signal wave signal. As shown, all harmonics are no longer present at the gate 30 or at gate level.

In fig. 2b a further form of embodiment of an electronic driver circuit 10 for at least one power MOSFET 20 is shown. In this case the piezoelectric resonator 25 is connected in parallel with the driving signal generator 15. In other words, in fig. 2b a parallel resonance implementation is shown. In such a case, if resonance is present the input impedance is at a maximum and is extremely small at other frequencies. In the form of embodiment shown in fig. 2b the driving signal generator 15 must generate a sinusoidal signal. The capacitance $C_0$ shown in figs. 2a and 2b represents the capacitance at the gate 30, namely the total gate capacitance. The piezoelectric resonators 25 generate no measurable magnetic field. The rejection effect due to the series resonance leads to a sharp reduction in the high-frequency harmonics which dominate the outer field generated by the drive current loops.

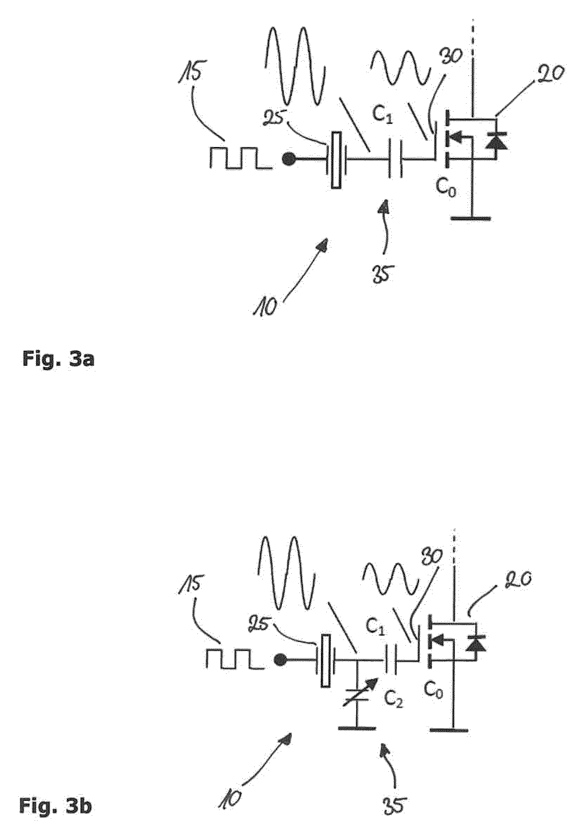

Known piezoelectric resonators have an optimum load capacitance which at 4 MHz is approximately 40 pF and at 16 MHz reduces to approximately 10 pF. These capacitance values are generally much lower than the capacitance values at the gate 30 of the power MOSFETs 20. Therefore, impedance-matching units as described in fig. 3a and 3b are required in some forms of embodiment.

Fig. 3a shows a form of embodiment which with the aid of a simply designed impedance-matching unit 35 minimises the number of piezoelectric elements that become necessary. As known piezoelectric resonators withstand much higher voltages than the gates of the MOSFETs (typically in a range from 100 volts to 200 volts), a simple impedance-matching unit 35 can be formed by a capacitive bridge divider. A reduction in capacitance is achieved through the series-connected capacitor $C_1$. To obtain a down voltage ratio, the capacitor $C_1$, which has a lower capacitance value than the capacitance $C_0$ applied at the gate, is connected in series to the gate. In connection with this, the best result is obtained if the entire series capacitance attains the optimal external capacitance for the piezoelectric resonator 25.

If the capacitance $C_0$ is too small to achieve a suitable voltage at the gate 30 or at gate level, a capacitor connected in parallel can be added to the impedance-matching unit 35.

Such an additional capacitor $C_2$ is shown in fig. 3b. This is located between the high-level output side of the piezoelectric resonator 25 and the source of the power MOSFET. The capacitance can be varied by, for example, designing the capacitor 2 as a variable capacitor so that the best-possible Q factor can be achieved. For most piezoelectric resonators the Q factor depends less on the external capacitive load. This optional capacitance can be used to adjust the input resonance to the assumed frequency.

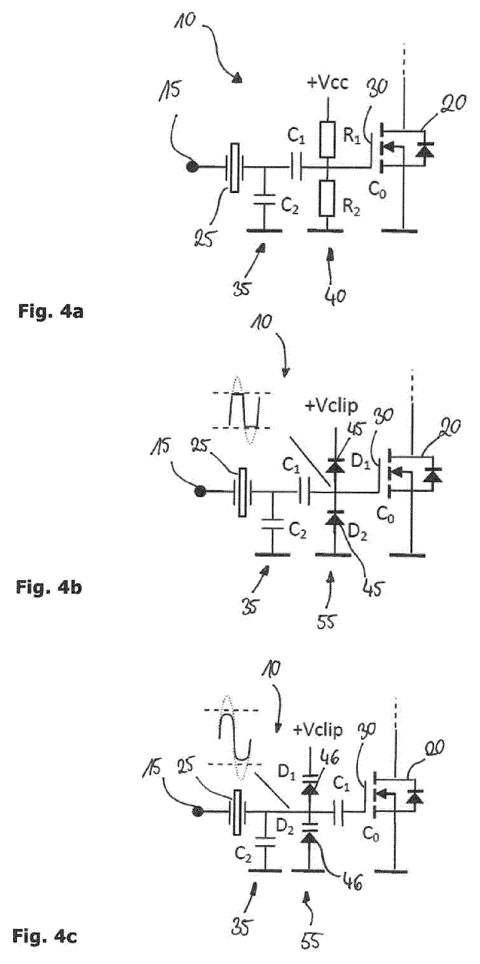

Shown in fig. 4a is an electronic driver circuit 10 wherein between the piezoelectric resonator 25 and the gates 30 of the MOSFETs 20 an ohmic voltage divider 40 is connected, particularly in such a way that there is a voltage offset on the gate 30. The voltage at the gate 30 can be adjusted in such a way that the MOSFET 20 switches from "ON" to "OFF" or vice-versa as soon as the sinus wave component crosses the zero value or when the signal generated by the driving signal generator 15 reaches the peak of the rate of rise. The offset position can optionally be used to control the dead time between the series transistor switching operations.

In fig. 4b a further electronic driver circuit 10 is shown which has a clipping unit 55 with clipping diodes 45. The clipping diodes 45 prevent the voltage at the gate 30 reaching too high values.

In contrast, a clipping unit with varactors 46 is shown in fig. 4c. In connection with this it is indicated how the signal form is changed due to the varactors 46. A sinusoidal signal can be converted into an almost square wave signal. Close to the forward voltage these varactors 46 have a high capacitance value. The junction capacitance of the diodes is greatest shortly before the clipping, i.e. the "cutting off" of the sinus wave form. Preferably the varactors 46 have a maximum capacitance which is similar to or greater than the capacitance at the gate 30 of the MOSFET 20. Near conduction the barrier layer capacitance is much greater so that a non-linear energy store is made available. This effect leads to a voltage form which is more like a square wave whereby losses are avoided or delayed due to diode conduction.

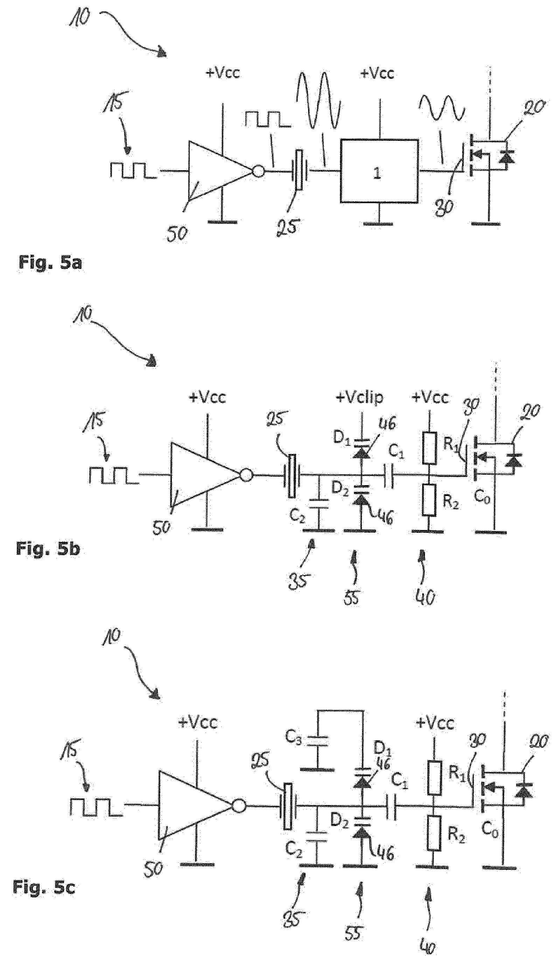

As shown in fig. 5a, the electronic driver circuit 10 can comprise a CMOS logic module or a TTL logic module 50. Such a logic module 50 can be used to operate a single power MOSFET 25 with high frequencies. Box 1 represents a placeholder expressing that the output signal of the at least one piezoelectric resonator 25 is modified by impedance matching and/or frequency tuning and/or a clipping method and/or a shaping method and/or by offsetting and the modified output signal is forwarded as an input signal to the gate 30 of the at least one power MOSFET 20.

Fig. 5b shows a combination of an ohmic voltage divider 40 with the arrangement of clipping diodes 45. The impedance-matching unit 35 is formed by the capacitors $C_1$ und $C_2$. Accordingly fig. 5b shows the combination of an impedance-matching unit 35 with an ohmic voltage divider 40. On the basis of the resistances $R_1$ und $R_2$ offsetting can be carried out. On the other hand, by way of the varactors 46 of the clipping unit 55 a clipping method can be carried out.

Shown in fig. 5c is the implementation of an automatic shaping/clipping voltage. In this case the capacitance of capacitor $C_3$ must be much greater than the sum of the capacitances $C_1$ und $C_2$ in order to exhibit an almost flat behaviour close to the forward voltage. In relation to the capacitance $C_0$ the impedance-matching unit 35 formed by capacitor $C_1$ and capacitor $C_2$ should be provided on gate 30 of the MOSFET 20 so that the voltage at the gate 30 does not exceed the maximum permitted value of the MOSFET 20.

In a further form of embodiment of the invention a high resistance or a Zener diode can be connected in parallel with the capacitor $C_3$ so that a clipping voltage anomaly due to the presence of glitches in the input signal is prevented. Furthermore, by way of Zener diode of this type or a resistance connected in parallel it is possible to maintain or limit the clipping voltage level.

As shown in fig. 6, with the aid of the electronic driver circuit 10 according to the invention it is possible to arrange two power MOSFETs 20 in one half-bridge driver circuit. The input frequencies can be 2 - 20 MHz. This makes it possible to generate a quasi square wave output signal with an extremely small proportion of harmonics. The shown level shifter 3 is used to drive the illustrated upper MOSFET 20. The upper logic voltage can be produced through using a standard bootstrap method (not shown). Offset control allows the reduction of superimposed currents. This takes place by controlling the dead time between the two switching operations for the MOSFETs 20.

In fig. 7 four power MOSFETs 20 in a full-bridge circuit are shown. In this electronic driver circuit too only two piezoelectric resonators 25 are required. In the example of embodiment according to fig. 7 no level shifter is required. In the case of voltages $Vcc_{out}$, which are much higher than the voltage Vcc it is advantageous if the half-bridge structure is operated with the opposite phase.

List of reference numbers

**[0071]**

10   Electronic driver circuit

15   Driving signal generator

20   MOSFET

25   Piezoelectric resonator

30   Gate

35   Impedance-matching unit

40   Ohmic voltage divider

45   Clipping diode

46   Varactor

50   Logic module

55   Clipping unit

**Claims**

1.   Electronic driver circuit (10) for at least one power MOSFET (20), comprising at least one driving signal generator (15) and at least one piezoelectric resonator (25) whose output signal is applied directly or indirectly to the gate (30) of at least one power MOSFET (20).

2.   Electronic driver circuit (10) according to claim 1, **characterized in that** at least one piezoelectric resonator (25) is connected in parallel or in series with the driving signal generator (15).

3.   Electronic driver circuit (10) according to claim 1 or 2, **characterized in that** an impedance matching unit (35) is connected between at least one piezoelectric resonator (25) and the gate (30) of at least one power MOSFET (20).

4.   Electronic driver circuit (10) according to claim 3, **characterized in that** the impedance matching unit (35) comprises at least one first capacitor ($C_1$) which is connected in series with the gate (30) of the power MOSFET (20).

5.   Electronic driver circuit (10) according to claim 4, **characterized in that** the impedance matching unit (35) comprises at least one second capacitor ($C_2$) which is connected in parallel with a serial assembly of the first capacitor ($C_1$) and an input capacitance ($C_0$) of the power MOSFET (20).

6.   Electronic driver circuit (10) according to one of the preceding claims, **characterized in that** a resistive voltage divider (40) is connected between a reference voltage and ground, wherein the intermediate voltage is applied to the gate (30) of at least one power MOSFET (20), especially such that a voltage offset is applied to the gate (30).

7. Electronic driver circuit (10) according to one of the preceding claims,
   **characterized in that**
   at least one clipping unit (55) is provided between at least one piezoelectric resonator (25) and the gate (30) of at least one power MOSFET (20), said clipping unit (55) comprising at least two diodes, especially at least two clipping diodes (45) or at least two varactors (46).

8. Electronic driver circuit (10) according to claim 7,
   **characterized in that**
   the diodes (45, 46) have a large capacitance value near the forward voltage.

9. Electronic driver circuit (10) according to claim 7 or 8,
   **characterized in that**
   the diodes (45) or varactors (46) connected in series are connected on one side between two voltage references, especially the ground or the source of the power MOSFET (20), and on the other side to the gate (30) of the power MOSFET (20).

10. Electronic driver circuit (10) according to claim 9,
    **characterized in that**
    the diodes (45, 46) are arranged such that the voltage applied to the gate (30) of the power MOSFET (20) can adopt a value between the two voltage references and the value of the voltage references can be exceeded merely up to the value of the threshold voltage of the diodes (45, 46).

11. Electronic driver circuit (10) according to claim 9 or 10,
    **characterized by**
    a capacitor which is connected on one side to the ground or the source of the power MOSFET (20) and on the other side to the anode of one of the diodes (45, 46).

12. Electronic driver circuit (10) according to one of the preceding claims,
    **characterized by**
    the combination with at least one further electronic driver circuit (10) according to one of the preceding claims.

13. Electronic driver circuit (10) according to one of the preceding claims, especially claim 12,
    **characterized in that**
    two power MOSFETs (20) are configured as part of a half-bridge driver circuit and/or four power MOSFETs (20) are configured as part of a full-bridge driver circuit.

14. Method for operating at least one power MOSFET (20) comprising an electronic driver circuit (10) according to one of claims 1 to 13,
    **characterized in that**
    the output signal of the at least one piezoelectric resonator (25), which has the resonance frequency of the piezoelectric resonator (25), is transmitted as input signal to the gate (30) of the at least one power MOSFET (20).

15. Method according to claim 14,
    **characterized in that**
    the output signal is modified by impedance matching and/or frequency tuning and/or a clipping method and/or a shaping method and/or by offsetting, and the modified output signal is transmitted as input signal to the gate (30) of the at least one power MOSFET (20).

**Fig. 1a**        **State of the art**

**Fig. 1b**        **State of the art**

**Fig. 2a**

**Fig. 2b**

**Fig. 3a**

**Fig. 3b**

**Fig. 4a**

**Fig. 4b**

**Fig. 4c**

Fig. 5a

Fig. 5b

Fig. 5c

Fig. 6

Fig. 7

Europäisches
Patentamt

European
Patent Office

Office européen
des brevets

# EUROPEAN SEARCH REPORT

Application Number

EP 16 16 1044

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 637 875 A1 (MOTOROLA INC [US]) 8 February 1995 (1995-02-08) | 1,2,14 | INV. H03K17/16 |
| A | * column 3, line 30 - line 32; figure 2 * <br> * column 4, line 11 - line 25 * | 3-13,15 | ADD. H03K17/041 |
| X | DE 30 40 530 A1 (SIEMENS AG [DE]) 13 May 1982 (1982-05-13) | 1,2,14 | H02M1/08 H03F3/217 |
| A | * page 5, line 1 - line 13; figure 1 * | 3-13,15 | H03K17/0412 |
| X | US 5 422 804 A (CLARK GEORGE E [US]) 6 June 1995 (1995-06-06) | 1,2,6, 14,15 | |
| A | * column 2, line 42 - line 44; figure 1 * | 3-5,7-13 | |
| X | JP 3 111202 B2 (TODA KOJI) 20 November 2000 (2000-11-20) | 1,2,14 | |
| A | * paragraph [0032] - paragraph [0033]; figure 5 * | 3-13,15 | |
| X | US 4 392 074 A (KLEINSCHMIDT PETER [DE] ET AL) 5 July 1983 (1983-07-05) | 1,2,14 | TECHNICAL FIELDS SEARCHED (IPC) |
| A | * column 2, line 14 - line 23; figure 9 * | 3-13,15 | H03K H02M H03F |

The present search report has been drawn up for all claims

| Place of search | Date of completion of the search | Examiner |
|---|---|---|
| The Hague | 12 September 2016 | O'Reilly, Siobhan |

EPO FORM 1503 03.82 (P04C01)

## ANNEX TO THE EUROPEAN SEARCH REPORT
## ON EUROPEAN PATENT APPLICATION NO.

EP 16 16 1044

This annex lists the patent family members relating to the patent documents cited in  the above-mentioned European search report.
The members are as contained in the European Patent Office EDP file on
The European Patent Office is in no way liable for these particulars which are merely given for the purpose of information.

12-09-2016

| Patent document cited in search report | | Publication date | Patent family member(s) | | Publication date |
|---|---|---|---|---|---|
| EP  0637875 | A1 | 08-02-1995 | EP<br>JP | 0637875 A1<br>H0767200 A | 08-02-1995<br>10-03-1995 |
| DE 3040530 | A1 | 13-05-1982 | NONE | | |
| US 5422804 | A | 06-06-1995 | US<br>US<br>US | 5422804 A<br>5644263 A<br>5986900 A | 06-06-1995<br>01-07-1997<br>16-11-1999 |
| JP 3111202 | B2 | 20-11-2000 | JP<br>JP | 3111202 B2<br>H05261324 A | 20-11-2000<br>12-10-1993 |
| US 4392074 | A | 05-07-1983 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5264736 A
- US 7453292 B2
- US 7285876 B1